# EUROPÄISCHE PATENTSCHRIFT

(11) **EP 1 700 363 B1**
(45) Veröffentlichungstag und Bekanntmachung des Hinweises auf die Patenterteilung: **07.07.2010**
(21) Anmeldenummer: 04802833.6
(22) Anmeldetag: 25.11.2004
(51) Int. Cl.: H01S 5/183, H01S 5/34, H01L 33/00, H01S 5/04

(54) **Verfahren zur Herstellung von Halbleiterschichtenfolgen für optisch gepumpte Halbleitervorrichtungen**
Method for fabricating semiconductor layer stacks for optically pumped semiconductor devices
Procédé pour fabriquer des empilements de couches de dispositifs semi-conducteurs à pompage optique

(30) Priorität: 25.11.2003 DE 10355357
(43) Veröffentlichungstag der Anmeldung: 13.09.2006
(60) Teilanmeldung: 09014857.8
(73) Patentinhaber: Philipps Universität Marburg, 35032 Marburg (DE)
(72) Erfinder: STOLZ, Wolfgang, 35041 Marburg (DE); LUTGEN, Stephan, 93047 Regensburg (DE)
(74) Vertreter: Buchhold, Jürgen
(86) Internationale Anmeldenummer: PCT/DE2004/002624
(87) Internationale Veröffentlichungsnummer: WO 2005/053125

(56) Entgegenhaltungen:
- ELLMERS C ET AL: "GaAs-based VCSEL-structures with strain-compensated (GaIn)As/Ga(PAs)-MQWH active regions grown by using TBAs and TBP - Theory and Practice" JOURNAL OF CRYSTAL GROWTH, NORTH-HOLLAND PUBLISHING CO. AMSTERDAM, NL, Bd. 195, Nr. 1-4, 15. Dezember 1998 (1998-12-15), Seiten 630-636, XP004154328 ISSN: 0022-0248
- ELLMERS C ET AL: "Optically pumped (GaIn)As/Ga(PAs) vertical-cavity surface-emitting lasers with optimized dynamics" APPLIED PHYSICS LETTERS, AMERICAN INSTITUTE OF PHYSICS. NEW YORK, US, Bd. 74, Nr. 10, 8. März 1999 (1999-03-08), Seiten 1367-1369, XP012022140 ISSN: 0003-6951
- OKUNO YAE L ET AL: "1.3 &mgr;m wavelength vertical cavity surface emitting laser fabricated by orientation-mismatched wafer bonding: A prospect for polarization control" APPLIED PHYSICS LETTERS, AMERICAN INSTITUTE OF PHYSICS. NEW YORK, US, Bd. 82, Nr. 15, 14. April 2003 (2003-04-14), Seiten 2377-2379, XP012033735 ISSN: 0003-6951
- AE S ET AL: "LOW THRESHOLD LAMBDA = 1.3 MUM MULTI-QUANTUM WELL LASER DIODES GROWN BY METALORGANIC VAPOR PHASE EPITAXY USING TERTIARYBUTYLARSINEAND TERTIARYBUTYLPHOSPHINE PRECURSORS" JOURNAL OF CRYSTAL GROWTH, NORTH-HOLLAND PUBLISHING CO. AMSTERDAM, NL, Bd. 145, Nr. 1/4, 2. Dezember 1994 (1994-12-02), Seiten 852-857, XP000511795 ISSN: 0022-0248
- KIM I ET AL: "Composition control of InGaAsP in metalorganic chemical vapor deposition using tertiarybutylphosphine and tertiarybutylarsine" JOURNAL OF CRYSTAL GROWTH, NORTH-HOLLAND PUBLISHING CO. AMSTERDAM, NL, Bd. 193, Nr. 3, 1. Oktober 1998 (1998-10-01), Seiten 293-299, XP004144972 ISSN: 0022-0248
- OUGAZZADEN A ET AL: "High performance strained MQW lasers at 1.3 µm by MOVPE using arsine generator system" ELECTRONICS LETTERS, IEE STEVENAGE, GB, Bd. 30, Nr. 20, 29. September 1994 (1994-09-29), Seiten 1681-1682, XP006001121 ISSN: 0013-5194
- HOU H Q ET AL: "HIGH-PERFORMANCE 1.06-MUM SELECTIVELY OXIDIZED VERTICAL-CAVITY SURFACE-EMITTING LASERS WITH INGAAS-GAASP STRAIN-COMPENSATED QUANTUM WELLS" IEEE PHOTONICS TECHNOLOGY LETTERS, IEEE INC. NEW YORK, US, Bd. 9, Nr. 8, August 1997 (1997-08), Seiten 1057-1059, XP000699797 ISSN: 1041-1135
- HOLMES A.L. ET AL: 'InP-based multiple quantum well structures grown with tertiarybutylarsine (TEA) and tertiarybutylphosphine (TBP): effects of growth interruptions on structural and optical properties' JOURNAL OF ELECTRONIC MATERIALS Bd. 25, Nr. 6, 01 Juni 1996, Seiten 965 - 971
- SCHLENKER D. ET AL: 'Growth of highly strained GaInAs/GaAs quantum wells for 1.2mum wavelength lasers' JOURNAL OF CRYSTAL GROWTH, ELSEVIER, AMSTERDAM, NL Bd. 209, Nr. 1, 15 Januar 2000, Seiten 27 - 36
- SETIAGUNG C. ET AL: 'Very low threshold current density of 1.3 /spl mu/m-range GaInNAsSb//GaNAs 5QWs lasers' 2002 IEEE 18TH. INTERNATIONAL SEMICONDUCTOR LASER CONFERENCE. GARMISCH, GERMANY, SEPT. 29 - OKT. 3, 2002; [IEEE INTERNATIONAL SEMICONDUCTOR LASER CONFERENCE], NEW YORK, NY : IEEE, US 29 September 2002, Seiten 39 - 40
- GOUARDES E. ET AL: 'GaInAs-GaInNAs-GaInAs Intermediate Layer Structure for Long Wavelength Lasers' IEEE PHOTONICS TECHNOLOGY LETTERS Bd. 14, Nr. 7, Juli 2002, Seiten 896 - 898
- KAWAGUCHI M. ET AL: 'Photoluminescence and lasing characteristics of 1.3 mum GaInNAs/GaAsP/GaAs strain-compensated quantum wells' COMPOUND SEMICONDUCTORS, 2003. INTERNATIONAL SYMPOSIUM ON 25-27 AUG. 2003, PISCATAWAY, NJ, USA,IEEE 25 August 2003, Seiten 72 - 73

## Beschreibung

Die vorliegende Erfindung beschreibt die Herstellung und Realisierung von langwelligen MILOS-Scheibenlasern (MILOS=Monolithic Integrated Lateral Optical Pumped Semiconductor), extern optisch Barriere/Quantenfilm-gepumpten und elektrisch gepumpten Scheibenlasem mittels Epitaxie (MOVPE) sowie ein Verfahren zur Kompensation von Verspannungen der darin eingesetzten Schichten.

### Stand der Technik

Die hier diskutierten optisch gepumpten Halbleiterlaserstrukturen bestehen im wesentlichen aus einer Einkoppelschicht, einem aktiven Bereich aus Quantenfilmen, die so angeordnet sind, dass sie einen optimalen Überlapp zu dem Lichtfeld des Pumplasers aufweisen, und einem epitaktischen (lambda/4) Vielschichtspiegel (Distributed Bragg-Reflektor (DBR), der das emittierte Licht der Quantenfilme zurückspiegelt und somit in dem Laserresonator den hochreflektierenden Endspiegel darstellt.

Für die darin bekannterweise verwendeten Schichtstrukturen wird mit zunehmender Emissionswellenlänge und damit zunehmender Verspannung der Einbau verspannungskompensierender Schichten immer wichtiger. Diese kompressive Verspannung muß in den hier zur Diskussion stehenden Schichtfolgen, die zu einer effizienten Absorption des Pumplichtes im Bereich von z.B. 5 bis 25 oder mehr aktive Quantenfilmpaketen enthalten muß, durch zugverspannte Schichten kompensiert werden.

Für die Realisierung von langwelligen Scheibenlasem >1000nm werden für die Lichterzeugung kompressiv verspannte InGaAs-Quantenfilme mit In-Konzentrationen mit typ. >18% und Schichtdicken mit typ. <10nm benötigt. Diese können z.B. bei MOVPE-Wachstumstemperaturen von >600°C mit guter Qualität nur für Wellenlängen bis ca. 1000nm hergestellt werden, da oberhalb der kritischen Schichtdicke eine Relaxation der verspannten Einzelschichten einsetzt. Eine weitere Erhöhung der kritischen Schichtdicke kann durch eine geringerer Energiezufuhr, d.h. z.B. durch eine niedrigere Wachstumstemperatur T<600°C erzielt werden.

Quantenwellstrukturen mit aktiven Schichten auf der Basis von GalnAs/GaPAs und GaInNAsSb/GaNAs sind in den folgenden beiden Dokumenten beschrieben: C. Ellmers et al. "GaAs-based VCSEL-structures with strain-compensated (Galn)As/Ga(PAs)-MQWH active regions grown by using TBAs und TBP (Journal of Crystal Growth, Bd. 198, 1998, Seiten 630 - 636); C. Setiagung et al. "Very Low Threshold Current Density of 1.3 µm-range GaInNAsSb/GaNAs 5Qws Lasers" (2002 IEEE 18TH. INTERNATIONAL SEMICONDUCTOR LASER CONFERENCE. GARMISCH, Deutschland, 29. Sept. - 03. Okt. 2002; Seiten 39 - 40).

### Nachteil im Stand der Technik

Die bislang in der MOVPE eingesetzten AsH3- und PH3-Gruppe-V-Gasquellen weisen bei dieser geringen Energiezufuhr, d.h. z.B. in Form einer Wachstumstemperatur von T<600°C sehr schlechte Zerlegungseigenschaften auf.

Aufgrund der geringen Zerlegungseffizienz von AsH3- und PH3-Gruppe-V-Gasquellen in der MOVPE bei diesen niedrigen Temperaturen ist der Einsatz alternativer Quellen für As und P notwendig.

### Aufgabe

Aufgabe der vorliegenden Erfindung ist es daher ein Verfahren gemäß Anspruch 1 zur Kompensation von Verspannungen in den Schichtfolgen optisch gepumpter Halbleitervorrichtungen zur Erzeugung von Strahlung, insbesondere langwelliger Strahlung unter Verwendung des oben benannten Epitaxie-Verfahrens vorzusehen.

Mit den durch dieses Verfahren hergestellten Schichtfolgen können qualitativ hochwertigere optisch gepumpte Halbleitervorrichtungen und generell besser verspannungskontrollierte Halbleitermehrfachschichtstrukturen erzeugt werden.

### Lösung der Aufgabe

Überrraschenderweise wurde dazu gefunden, dass in MOVPE-Epitaxieverfahren bei geringer Energiezufuhr und bei geringen Temperaturen, d.h. von T<600°C dann eine vorteilhafte Verspannungskompensation erreicht wird, wenn neben den bekannten N-Quellen (Hydrazine, wie 1,1-Dimethylhydrazin ((CH3)2N-NH2, UDMHy) oder auch Tertiärbutylhydrazin ( t-C4H9HN-NH2)) und bekannten Sb-Quellen unter Verwendung von TBAs- und/oder TBP-Quellen (Tertiärbutylarsin, d.h. (t-C4H9AsH2), bzw. Tertiärbutylphosphin (t-C4H9PH2, TBP)) Schichten -innerhalb der in ihrer einzelnen oder gemeinsamen Spannung zu kompensierenden Schichten-, z.B. aus Ga(PAs) oder/und Ga(NAs) oder/und (Galn)(NAs) bei der Epitaxie abgeschieden werden. Besonders vorteilhaft sind dabei derartige Schichten, welche zusätzlich als zugverspannte Schichten ausgeführt sind.

Neben InGaAs-Quantenfilmen können mit entsprechenden N-Quellen (Hydrazin) und Sb-Quellen InGaAsN, InGaAsSb, InGaAsNSb, GaAsN, AIAsN, GaAsSb, A-IAsSb, GaAsP-Schichten als Quantenfilm- und Barrierenstrukturen auf GaAs hergestellt werden. Damit können insbesondere in der MOVPE folgende GaAsbasierende Wellenlängen für Scheibenlaser/ VECSEL zugänglich gemacht werden (VECSEL=Vertical External Cavity Surface Emitting Laser):

| Quantenfilme: | Wellenlängen: |
|---|---|
| | |
| InGaAs | <1000nm (Standardquellen) |
| InGaAs | <1100nm (TBAs, TBP) |
| InGaAsN | <1300nm/1500nm (TBAs, TBP) |
| InGaAsNSb | <2000nm (TBAs, TBP, Sb-Quellen) |

Die Erfindung beschränkt sich im Bezug auf die oben genannten Quantenfilme auf das im Anspruch 1 definierte Material (InGaAsNSb).

Das Design je nach Wellenlänge ist insbesondere für effiziente Scheibenlaserstrukturen kritisch. Mit geeigneten Strukturen sind die zwei (fundamentalen) Wellenlängen 1050nm (frequenzverdoppelt grün) und 1260nm (frequenzverdoppelt rot) realisierbar.. Diese Wellenlängen eröffnen neben den bisher bekannten Wellenlängen u.a. den ganzen sichtbaren Wellenlängen durch resonatorinterne Frequenzverdopplung.

Zur Erläuterung der Erfindung sei als Beispiel, das nicht zur Erfindung gehört, auf InGaAs-Quantenfilme verwiesen.

Bei der Epitaxie von Scheibenlasern bei 1050nm Emissionswellenlänge kann eine erhöhte In-Konzentration bei niedrigen Wachstumstemperaturen von T<600°C mit den oben genannten TBAs-Quellen für die InGaAs-Quantenfilme zur Lichterzeugung und TBP-Quellen für die verspannungskompensierenden Barrierenschichten in der aktiven Schicht realisiert werden. Bei dieser Wellenlänge ist i.d.R. noch keine Verspannungskompensation der hochaluminiumhaltigen Schichten, die insbesondere in den Braggreflektoren zum Einsatz kommen, notwendig.

Insbesondere für Scheibenlaser bei längeren Wellenlängen ist dann i.d.R. auch eine Kompensation der Verspannung des Braggspiegels bei niedrigen Wachstumstemperaturen für die unterschiedlichen Materalien (typ. AlAs-, GaAs-, bzw. AlxGa(1-x)As-Schichten mit varierendem AI-Gehalt) mit Brechungsindexsprung vorteilhaft, da bereits während der Epitaxie diese Materialkombinationen unterschiedliche thermische Ausdehnungekoeffizienten haben und zu einer Materialdegradation führen können.

Dazu gibt es verschiedene Verspannungskompensationskonzepte, bei der hier insbesondere in den hochaluminiumhalten AlGaAs/AlAs-Schichten durch geringe Konzentrationen von P die leicht kompressive Verspannung durch das Aluminum tensil kompensiert werden kann. Die Barrierenschichten müssen je nach optischer Absorptionswellenlänge und -konzept für einen effizienten Betrieb sehr kritisch untersucht werden. Als Absorptionsschicht kann neben GaAsP und AlGaAs-Schichten für Absorptionswellenlängen <900nm auch InGaAsN oder GaAsN mit Absorptionswellenlängen >900nm erfindungsgemäß hergestellt werden. Dabei ist je nach Materialkombination auf das ausreichende Ladungsträgerkonfinement in Leitungs- und Valenzband zu achten. Insbesondere für InGaAsN-Quantenfilme zur Lichterzeugung ist ein ausreichendes Löcherkonfinement durch den Einsatz von GaAsP/AIGaAs-Schichten im Design für einen effizienten Laserbetrieb notwendig. Das erfindungsgemäße Verfahren ist insbesondere für Scheibenlaser-Varianten für höhere Wellenlängen von großem Vorteil. Die Herstellung solcher Scheibenlaser sind aufgrund der Frequenzverdopplung und entsprechender Farbzuordnung insbesondere im Bereich von 1260 nm wirtschaftlich sehr relevant.

Für die Schichtstrukturen wird mit zunehmender Emissionswellenlänge und damit zunehmender Verspannung der Einbau verspannungskompensierender Schichten immer wichtiger. Diese kompressive Verspannung muß in den hier zur Diskussison stehenden Schichtfolgen, die zu einer effizienten Absorption des Pumplichtes im Bereich von z.B. 5 bis 25 oder mehr aktive Quantenfilmpaketen enthalten muß, durch zugverspannte Schichten kompensiert werden. Hierzu kann man im aktiven Bereich entweder zugverspanntes Ga(PAs) einsetzen, wenn man mit einer Pumpwellenlänge unterhalb von 900 nm anregen möchte, oder zugverspanntes Ga(NAs) bzw. zugverspanntes (Galn)(NAs) einsetzen, wenn man mit längeren Pumpwellenlängen arbeiten möchten. Aufgrund des verbesserten Zerlegungsverhaltens lassen sich diese Schichtstrukturen kontrollierter, mit größerer lateraler Homogenität und präziser herstellen.

Ein einzelnes Quantenwellpaket kann dabei aus einem aber auch aus zwei Quantenfilmen bestehen.

Je größer die Emissionswellenlänge wird desto größer müssen auch die Schichtdicken der DBR-Struktur (Schichtaufbau aus lamda/4-Schichten) werden. Darüberhinaus wird der Unterschied des Brechungsindizes zwischen z.B. AlAs und GaAs mit zunehmender Wellenlänge kleiner, dies bedeutet, daß zur Erzielung eines gleich hohen Reflektionsgrades eine höhere Anzahl von DBR-Schichtpaaren abgeschieden werden muß. Da mit zunehmender Schichtdicke und Anzahl der der DBR-Paare auch für diese Struktur die integrale elastische Verspannung zunimmt, muß man auch für den DBR-Teil des Lasers eine Verspannungskompensation einbauen. Um die kompressive Verspannung des (AlGa)As-Teils zu kompensieren kann man einmal durch Zugabe von P- in diese Schicht die Verspannung abbauen ( DBR-Aufbau (Al(große Konz.)Ga)(PAs)/(Al(klein Konz.)Ga)As ). Zum anderen kann man auch die kompressive Verspannung des Al(groß)Ga)As durch zugverspanntes Ga(PAs) oder auch zugverspanntes (Al(klein)Ga)(PAs) kompensieren. Die mit dem erfindungsgemäßen Verfahren hergestellten optisch gepumpten Halbleitervorrichtungen zur Erzeugung von Strahlung weisen daher zur Verspannungskompensation entsprechende zug- oder kompressionsverspannte Halbleiterschichten auf, welche durch die Verwendung der oben genannten TBAs oder/und TBP-Quellen in bekannten MOVPE-Epitaxie-Verfahren erzeugt wurden.

## Patentansprüche

1. Verfahren zur Herstellung von Halbleiter-Schichtfolgen, für optisch gepumpte Halbleitervorrichtungen die als Licht erzeugende Schicht wenigstens einen Quantenfilm und die mindestens eine verspannungskompensierende Schicht für die umgebende Schicht oder die umgebenden Schichten enthalten, wobei die verspannungskompensierende Schicht eine zug- oder kompressionsverspannte Halbleiterschicht ist, die Arsen und/oder Phosphor aus TBAs- und/oder TBP-Quellen enthält, wobei die Licht erzeugenden Schichten und die verspannungskompensierenden Schichten mittels metallorganischer Gasphasenepitaxie (MOVPE) bei Temperaturen <600°C abgeschieden werden, der wenigstens eine Quantenfilm aus InGaAsNSb und die verspannungskompensierende Schicht aus Ga(PAs) und/oder Ga(NAs) oder/und (Galn)(NAs) besteht.

## Claims

1. Method for the production of semiconductor layer successions for optically pumped semiconductor devices which contain at least one quantum film as a light generating layer and at least one strain-compensating layer for the surrounding layer or the surrounding layers, wherein the strain-compensating layer is a tensile-strained or compressive-strained semiconductor layer containing arsenic and/or phosphorous from TBAs and/or TBP sources, wherein the light generating layers and the strain-compensating layers are deposited using metal organic vapor phase epitaxy (MOVPE) at temperatures of < 600°C, and wherein the at least one quantum film is comprised of InGaAsNSb and the strain-compensating layer is comprised of Ga(PAs) and/or Ga(NAs) or/and (Galn)(NAs).

## Revendications

1. Procédé pour la production d'une suite de couches semi-conductrices pour des dispositifs de semi-conducteurs pompés optiquement, qui contiennent comme couche génératrice de lumière au moins un puits quantique et au moins une couche compensant la distorsion pour la couche environnante ou les couches environnantes, où la couche compensant la distorsion est une couche semi-conductrice, déformée sous traction ou compression, qui contient de l'arsenic et/ou du phospore de sources TBA et/ou TBP, où les couches génératrices de lumière et les couches compensant la distorsion sont déposées au moyen d'épitaxie en phase vapeur aux organométalliques (EPVOM) à des températures < 600°C, et où l'au moins un puits quantique est constitué de InGaAsNSb et la couche compensant la distorsion de Ga(PAs) et/ou Ga(NAs) et/ou (Galn)(NAs).
